# EUROPEAN PATENT SPECIFICATION

(11) **EP 2 364 076 B1**
(45) Date of publication and mention of the grant of the patent: **18.07.2012**
(21) Application number: 11156161.9
(22) Date of filing: 28.02.2011
(51) Int. Cl.: H05K 7/20

(54) **Cabinet for cooling units for server rooms**
Schrank für Kühleinheiten für Server-Räume
Armoire pour unités de refroidissement pour salles de serveur

(30) Priority: 02.03.2010 IT PD20100061
(43) Date of publication of application: 07.09.2011
(73) Proprietor: EMERSON NETWORK POWER S.R.L., 35028 Piove di Sacco (Padova) (IT)
(72) Inventor: De Zen, Daniele, 35020, COREZZOLA PD (IT); Scattolin, Mario, 30037, SCORZE' VE (IT)
(74) Representative: Modiano, Micaela Nadia

(56) References cited:
- US-A1- 2007 165 377
- US-A1- 2008 037 217

## Description

The present invention relates to a cabinet for cooling units for server rooms.

So-called precision cooling units are known for example from US 2007/0165377, which are to be placed among rack cabinets supporting a plurality of servers or computers or other electronic units, in a server room measuring from 10 to 100 square meters, or in a data processing center of a small or medium business, or other technical rooms to be climate-controlled which have similar dimensions.

Such a cooling unit is typically located to the side of a row of side-by-side server cabinets, or between two server cabinets of a row of cabinets, so as to draw air from a so-called hot corridor to diffuse it in a so-called cold corridor, at the front part of the server cabinets and of the other IT devices.

The cooled air can be directed to the right, to the left or to both sides, depending on the requirements, by means of integrated and adjustable diffusers.

Such a unit can also be used in larger data processing centers to reduce the excess heat (so-called hot spots) that concentrates in particular areas for example due to the implementation of high-density solutions.

These cooling units for server rooms, which are currently known, widespread and highly appreciated, typically comprise a lower part, for the containment of conditioning means, which is closed by a first lower panel formed by a grill for the exit of the climate-controlled air, and an upper part for the containment of power supply and control components associated with the conditioning means, closed by a second upper panel.

In these units, the flow of climate-controlled air for conditioning the environment exits from the grill of the first lower panel, which directs the flow of treated air into the conditioned environment.

However, it has been found that in some typical layouts using such conditioning unit arranged to the side of a row of laterally adjacent racks or between two racks of a same row, insufficient air conditioning reaches the first rack that is laterally adjacent to the unit, and in particular the first servers contained in such first rack from the top, and in general the distribution of the air is poor, and this can lead to the risk of overheating of those specific servers and of the adjacent servers, with consequent danger of malfunction.

The aim of the present invention is to provide a cabinet for cooling units for server rooms, capable of improving the distribution of the climate-controlled air in the server room or in the other similar environment in which it is placed to work.

Within this aim, an object of the invention is to provide a cabinet for cooling units that is adapted to contain cooling and climate-control means of a per se known type.

Another object of the invention is to provide a cabinet that can be manufactured with low costs and with means of a per se known type.

In accordance with the invention, there is provided a cabinet for cooling units for server rooms as defined in the appended claims.

Further characteristics and advantages of the invention will become better apparent from the following detailed description of a preferred but not exclusive embodiment of the cabinet according to the invention, illustrated by way of non-limiting example in the accompanying drawings, wherein:
Figure 1 is a perspective view of a cabinet according to the invention;
Figure 2 is a perspective view of the second panel in the open configuration;

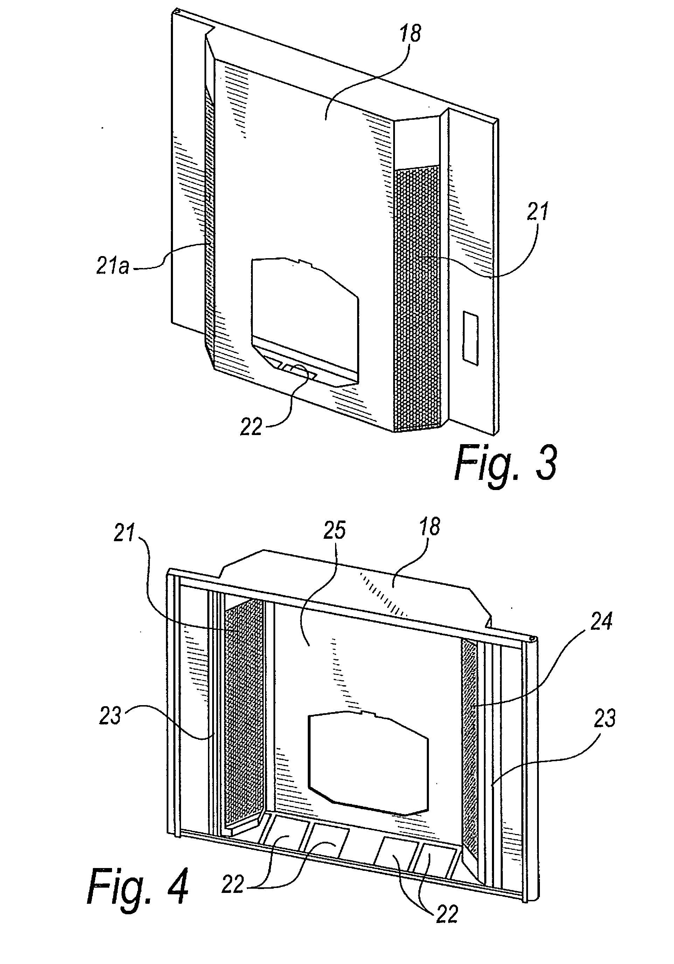

Figure 3 is a front perspective view of the second panel alone;
Figure 4 is a rear perspective view of the second panel alone;
Figure 5 is a schematic sectional side view of a detail of the panel according to the invention;
Figure 6 is a view of an example of application of a cabinet for cooling units of the known type;
Figure 7 is a view of an example of application of a cabinet according to the invention.

With reference to the figures, a cabinet for cooling units for server rooms is generally designated by the reference numeral 10.

The cabinet 10 contains a cooling unit, designated by the reference numeral 11.

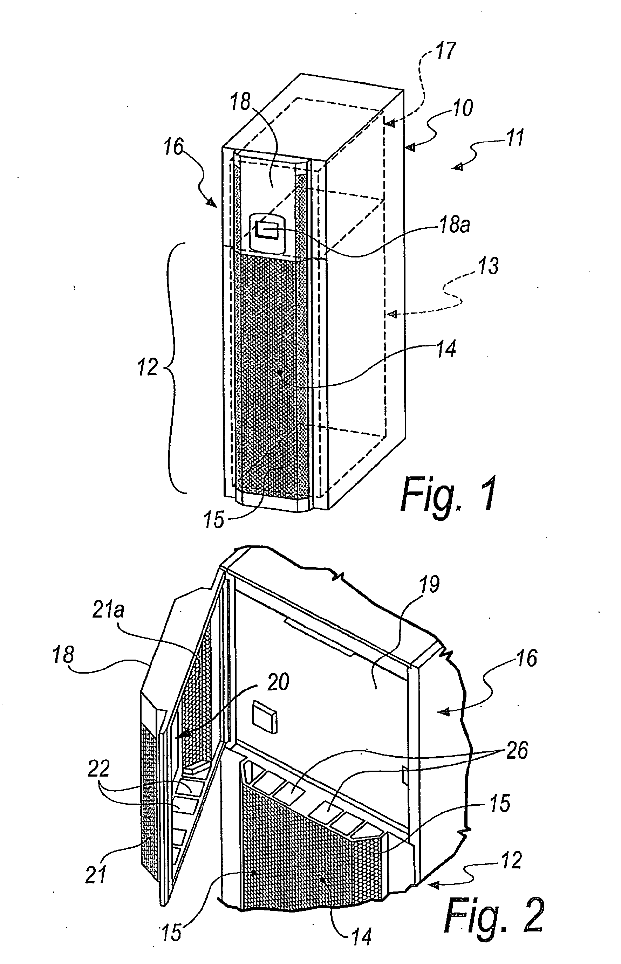

The cabinet 10 comprises a lower part 12 for containing conditioning means 13, to be understood as being of a per se known type and shown in dashed lines in Figure 1, which is closed by a first lower panel 14 which is at least partly formed by a grill 15 for the exit of the climate-controlled air.

In the embodiment described here, which is a non-limiting example of the invention, the first panel 14 has one grill 15.

The cabinet 10 also comprises an upper part 16 for the containment of electric power supply and control components 17, illustrated schematically by the parallelepiped in dashed lines, for example an electrical control panel, which are associated with the conditioning means 13.

The upper part 16 is closed by a second panel 18, which is exemplified here as a door but is to be understood as being also openable with other engagement and disengagement means or other reversible fixing means of a per se known type, which in the embodiment given here is provided with a display 18a for the management of the unit 11.

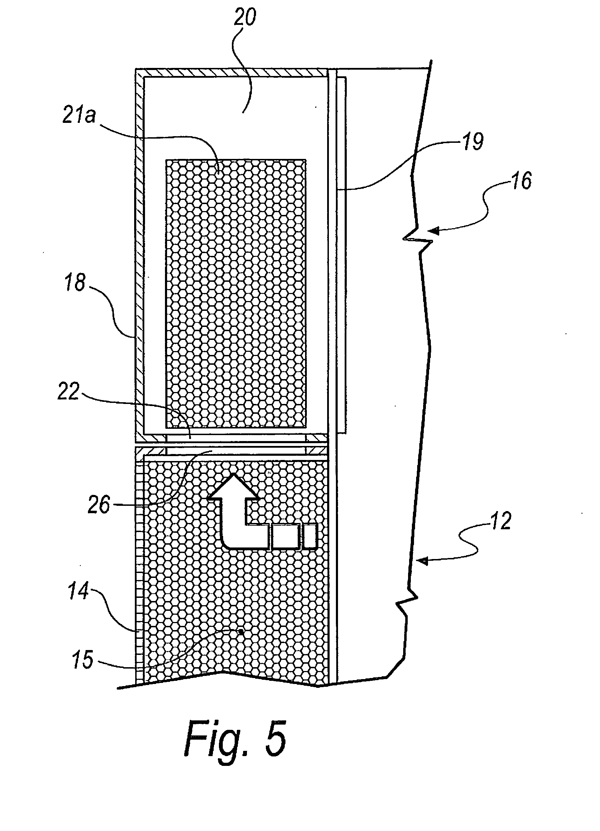

The particularity of the invention resides in that the second panel 18 defines, with a wall 19 for protecting the electric power supply components, an interspace 20, which is clearly visible in Figure 5, for the passage of the climate-controlled air that rises from the lower part 12 and has grill-like portions 21 and 21 a for the exit of such climate-controlled air.

The second panel 18 has lower openings 22 for the passage of the climate-controlled air from the conditioning means 13 contained in the lower part 12.

The grill-like portions 21 and 21 a are extended predominantly vertically along the lateral edges of the second panel 18.

The second panel 18, at the grill-like portions 21 and 21 a, has means for providing the at least partial closure of such grill-like portions.

In the embodiment of the invention described herein, such provision means are constituted by corresponding frames 23, which are preset to support detachably a mask 24 which is shaped so as to block the respective grill.

The closure of one grill-like portion 21 and 21a or the other allows to choose three installation solutions: with both grill portions 21 and 21 a open, with just the right grill portion open or with just the left grill portion open, depending on where one prefers to direct the flow of conditioned air.

The second panel 18 is shaped so as to have a substantially concave central part with the concavity 25 directed inward and extending upward from below with respect to the position of use of the panel 18, the concavity 25 cooperating to the formation of such interspace for the passage of conditioned air.

Likewise, the first panel 14 also is shaped so as to have a substantially concave central part with the concavity directed inward and extending upward from below with respect to the position of use of the first lower panel 14.

The first lower panel 14 has, in an upper region, at lower openings 22 of the second panel 18, respective openings 26 for the passage of the conditioned air from the lower part 12 of the unit 11 to the grill-like portions 21 and 21 a of the second panel 18.

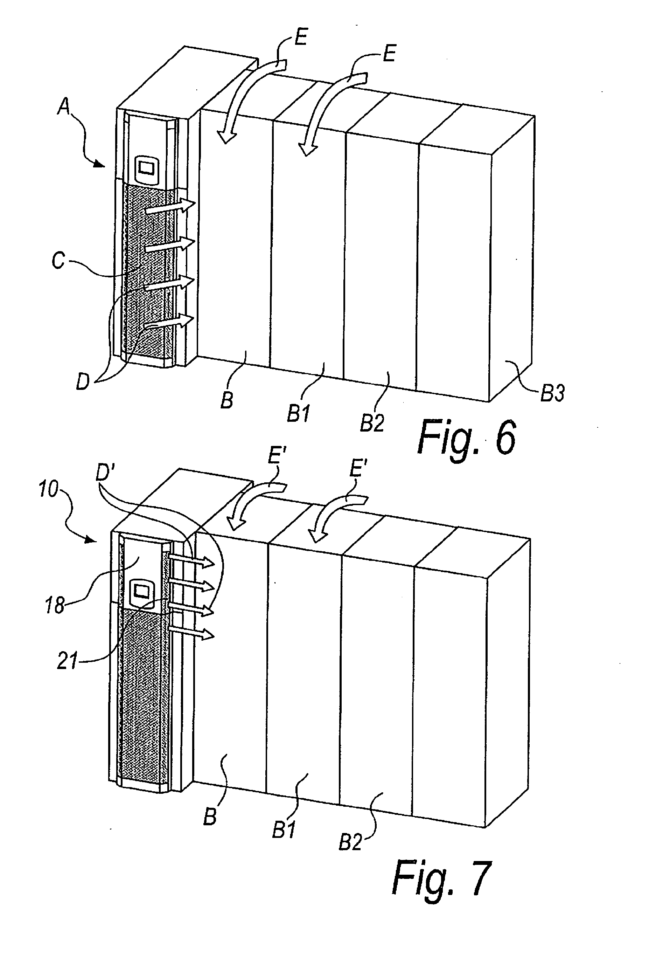

Figure 6 illustrates schematically an example of application of a cooling unit of the known type A, arranged to the side of a row of rack cabinets B, B1, B2 and so forth, each of which supports a plurality of servers or other computers.

Climate-controlled air exits from the first lower panel C of the unit A along an indicative direction illustrated by first arrows D.

Second arrows E indicate the recirculation of warm air from the rear "corridor" to the cabinets B, B1 and so forth, which flows around the first cabinets B and B1 in an upper region, overheating their upper part.

The climate-controlled air D in fact flows over the cabinets B and B1 only up to a certain height and is unable to contrast the warm air E in the upper part of the cabinets B and B1.

Figure 7 illustrates schematically the application to the same series of cabinets B, B1 and so forth of a cabinet 10, by virtue of which the climate-controlled air D' exits from the grill-like portion 21 of the second panel 18, cooling the first cabinets B and B1 in their uppermost part as well, repelling the flow E' of warm air that arrives from the rear hot corridor.

In practice it has been found that the invention achieves the intended aim and objects.

In particular, the present invention provides a cabinet for cooling units for server rooms which is capable of improving the distribution of the climate-controlled air in the server room or other similar enclosed space in which it is placed to work.

Thanks to the second upper panel, with lower openings of transit of climate-controlled air from the conditioning means, and thanks to the grill-like portions on the second panel, which allow the lateral exit of the climate-controlled air at the height of the upper part of the nearby rack cabinets, the cabinet according to the invention in fact allows to lower the temperature of the nearest cabinet parts, which are typically subjected to critical thermal situations with the use of currently known conditioning units.

Moreover, the invention provides a cabinet for cooling units which is adapted to contain cooling and climate-control means of a per se known type and is applicable immediately in server rooms, data processing centers and other similar environments, including ones that are already operational.

Moreover, the invention provides a cabinet that can be manufactured with low costs and with means of a per se known type.

The invention thus conceived is susceptible of numerous modifications and variations, all of which are within the scope of the appended claims; all the details may further be replaced with other technically equivalent elements.

In practice, the materials used, as well as the contingent shapes and dimensions, may be any according to requirements and to the state of the art.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A cabinet (10) for cooling units (11) for server rooms, of the type comprising a lower part (12) for containing conditioning means (13) closed by a first lower panel (14) that is at least partly formed by a grill (15) for the exit of climate-controlled air, and an upper part (16) for containing electric power supply and control components (17) associated with the conditioning means closed by a second upper panel (18) having a display (18a) for management of said unit (11), said second panel (18) forming, with a wall (19) for protecting said electrical panel, an interspace (20) for the passage of the climate-controlled air rising from said lower part (12) and having grill-like portions (21, 21a) for the exit of said climate-controlled air, said second panel (18) having lower openings (22), and said first panel (14) having, in an upper region thereof, respective openings (26) at said lower openings (22) of said second panel (18) for the passage of the climate-controlled air from said conditioning means contained in said lower part (12) to said grill-like portions (21, 21a) of said second panel (18), and said grill-like portions (21, 21a) extending predominantly vertically along lateral edges of said second panel (18).

2. The cabinet according to claim 1, **characterized in that** said second panel (18), at said grill-like portions (21, 21a), has means for providing an at least partial closure of said grill-like portions.

3. The cabinet according to claim 1, **characterized in that** said second panel (18) is shaped so as to have a concave central part with the concavity directed inward and extending upward from below with respect to a position of use of said second panel (18), said concavity cooperating to the formation of said interspace (20).

## Patentansprüche

1. Schrank (10) für Kühleinheiten (11) für Server-Raume des Typs umfassend ein Unterteil (12) für die Aufnahme von Konditionierungsmitteln (13), geschlossen durch eine erste untere Platte (14), die mindestens teilweise durch ein Gitter (15) für den Austritt von klimageregelter Luft ausgebildet ist, und ein Oberteil (16) für die Aufnahme von mit den Konditionisrungsmitteln verbundenen Stromlieferungs- und Regelungskomponenten (17), geschlossen durch eine zweite obere Platte (18), die eine Anzeige (18a) für das Management der Einheit (11) aufweist, wobei die zweite Platte (18) mit einer Wand (19) für den Schutz der elektrischen Platte einen Zwischenraum (20) für den Durchgang der klimageregelten von dem Unterteil (12) aufsteigenden Luft bildet und gitterähnliche Bereiche (21, 21a) für den Austritt der klimageregelten Luft aufweist, wobei die zweite Platte (18) untere Öffnungen (22) besitzt, und die erste Platte (14) in einer oberen zone davon entsprechende Öffnungen (26) an den unteren Öffnungen (22) der zweiten Platte (18) besitzt für den Durchgang der klimageregelten Luft von den Konditionierungsmitteln, die in dem Unterteil (12) enthalten sind, zu den gitterähnlichen Bereichen (21, 21a) der zweiten Platte (18), und die gitterähnlichen Bereiche (21, 21a) erstrecken sich überwiegend vertikal entlang seitlicher Kanten der zweiten Platte (18).

2. Schrank nach Anspruch 1, **dadurch gekennzeichnet, dass** die zweite Platte (18) an den gitterähnlichen Bereichen (21, 21a) Mittel für die Bereitstellung einer mindestens teilweisen Schließung der gitterähnlichen Bereiche aufweist.

3. Schrank nach Anspruch 1, **dadurch gekennzeichnet, dass** die zweite Platte (18) so geformt ist, dass sie ein konkaves Mittelteil aufweist. mit einwärts gerichteter wölbung und sich von unten aufwärts erstreckend bezüglich einer Benutzungsposition der zweiten Platte (18), wobei die Wölbung zu der Bildung des Zwischenraums (20) beiträgt.

## Revendications

1. Armoire (10) pour systèmes de refroidissement (11) pour salles de serveurs, du type comportant une partie inférieure (12) destinée à contenir des moyens de climatisation (13) et fermée par un premier panneau inférieur (14) qui est au moins partiellement formé par une grille (15) pour la sortie d'air conditionné, et une partie supérieure (16) destinée à contenir une source d'électricité et des organes de commande (17) associés aux moyens de climatisation et fermée par un second panneau supérieur (18)ayant un afficheur (18a) pour faire fonctionner ledit système (11), ledit second panneau (18) formant, avec une paroi (19) de protection dudit panneau électrique, un espace intermédiaire (20) pour le passage de l'air conditionné s'élevant depuis ladite partie inférieure (12) et ayant des parties analogues à des grilles (21, 21a) pour la sortie dudit air conditionné, ledit second panneau (18) ayant des ouvertures inférieures (22), et ledit premier panneau (14) ayant, dans une zone supérieure de celui-ci, des ouvertures respectives (26) au niveau desdites ouvertures inférieures (22) dudit second panneau (18) pour l'écoulement de l'air conditionné depuis les moyens de climatisation contenus dans ladite partie inférieure (12) jusqu'auxdites parties analogues à des grilles (21, 21a) dudit second panneau (18), et lesdites parties analogues à des grilles (21, 21a) s'étendant sensiblement verticalement le long de bords latéraux dudit second panneau (18).

2. Armoire selon la revendication 1, **caractérisée en ce que** ledit second panneau (18), dans lesdites parties analogues à des grilles (21, 21a) a des moyens pour réaliser une fermeture au moins partielle desdites parties analogues à des grilles.

3. Armoire selon la revendication 1, **caractérisée en ce que** ledit second panneau (18) est agencé de manière à avoir une partie centrale concave, la concavité étant orientée vers l'intérieur et s'étendant vers le haut depuis un emplacement en dessous par rapport à une position d'utilisation dudit second panneau (18), ladite concavité coopérant à la formation dudit espace intermédiaire (20).
